# EUROPÄISCHE PATENTSCHRIFT

(11) **EP 3 620 829 B1**
(45) Veröffentlichungstag und Bekanntmachung des Hinweises auf die Patenterteilung: **19.01.2022**
(21) Anmeldenummer: 18193290.6
(22) Anmeldetag: 07.09.2018
(51) Int. Cl.: G01V 8/20

(54) **LICHTGITTER**
LIGHT GRID
GRILLE LUMINEUSE

(43) Veröffentlichungstag der Anmeldung: 11.03.2020
(73) Patentinhaber: SICK AG, 79183 Waldkirch (DE)
(72) Erfinder: Eble, Johannes, 79183 Waldkirch (DE)

(56) Entgegenhaltungen:
- EP-A1- 1 939 652
- EP-A2- 1 503 226
- DE-A1-102014 115 946
- DE-U1-202016 104 285
- US-A- 4 015 122
- US-A1- 2016 320 525

## Beschreibung

Die Erfindung betrifft ein Lichtgitter mit mehreren Lichtsendeeinheiten zur Aussendung von Sendelichtstrahlen, mehreren Lichtempfangseinheiten, die entsprechend dem Lichteinfall Empfangssignale liefern und die zur Bildung des Lichtgitters die Sendelichtstrahlen bei freiem Strahlengang empfangen können, Empfangsoptiken und einer Auswerteeinheit zur Auswertung der Intensität des Lichteinfalls auf die Lichtempfangseinheiten.

Die Performance eines Lichtgitters hängt unter anderem von dem Sichtfeld der Empfänger ab, wobei das Sichtfeld insbesondere durch den Empfangswinkel bestimmt wird. Wird empfangsseitig eine Photodiode ohne zusätzliche Optik verwendet, liegt der Empfangsraumwinkel bei Ω = 2π, d.h. ohne zusätzliche Maßnahmen wird Licht aus einem Halbraum empfangen.

Dadurch ergeben sich Nachteile in beispielsweise folgenden Fällen:
- Benachbarte Lichtgitter müssen dann mit einem großen Relativabstand zueinander montiert werden, damit sie sich nicht gegenseitig stören, also das Licht des einen Lichtgitters nicht in das andere Lichtgitter gelangt.
- Das Licht von Störlichtquellen, wie Sonne oder künstliche Strahlungsquellen wie beispielsweise Halogenlampen, Laser oder LEDs, kann leicht in die Empfänger gelangen. Hierdurch kann es zu Fehlverhalten und Fehlschalten des Lichtgitters kommen.
- Abhängig von der Oberfläche von Objekten in der Umgebung des Lichtgitters müsste ein großer Mindestabstand zwischen den Strahlachsen des Lichtgitters und diesen Objekten eingehalten werden. Der Grund hierfür ist, dass das Sendelicht trotz eigentlicher Strahlunterbrechung durch das zu detektierende Objekte über Reflexionen an Umgebungsobjekten Licht empfangen kann und so ein Fehlschalten auslösen kann.

Um diese Nachteile zu vermeiden und damit die Performance des Lichtgitters zu steigern wird üblicherweise das Sichtfeld der Lichtempfänger des Lichtgitters eingeschränkt.

Dazu ist es bekannt, bei Lichtgittern die Empfangsoptik, die pro Lichtstrahl aus je einer Linse und einer Photodiode besteht, mit einer Blende auszurüsten. Die Brennweite der Linse und der Durchmesser der Blende, die üblicherweise im Brennpunkt der Linse liegt, bestimmen dann den Empfangswinkel (Sichtbereich) der Empfangsoptik.

Diese ist beispielsweise aus der US 4,015,122 bekannt.

Dies hat aber wiederum den Nachteil, dass die Empfangsoptik aufgrund der erforderlichen Brennweite der Linse und der Dicke der Linse viel Platz, typischerweise zwischen 10 mm und 20 mm, einnimmt. Zusätzlich zur Linse wird auch immer ein Tubus benötigt, um die Blende zu integrieren und insbesondere ungewolltes Licht zu blocken. Durch die Anzahl dieser Komponenten einer Empfangsoptik und die Anforderung einer exakten Positionierung der Komponenten relativ zueinander ist die Herstellung aufwändig und entsprechend kostenintensiv.

Aus der EP 1 939 652 A1 ist ein kamerabasierter Objektfeststellungssensor bekannt, bei dem ein Sichtbereich auf einen Bilaufnehmer abgebildet wird. Zur Steigerung der Auflösung und Verringerung er Bautiefe ist anstelle einer gewöhnlichen Linse ein Mikrolinsenarray eingesetzt. Das Mikrolinsenarray erzeugt Subbilder auf dem Bildaufnehmer, die zur Steigerung der Auflösung einzeln auswertbar sind.

Aus den Dokumenten DE 10 2014 115946 A1, EP 1 503 226A2, DE 20 2016 104285 U1, US 2016/320525 A1 sind weitere Verwendungen von Mikrolinsnearrays bekannt.

Ausgehend von diesem Stand der Technik ist es Aufgabe der Erfindung, ein verbessertes Lichtgitter bereitzustellen, mit dem die vorgenannten Nachteile vermieden werden können.

Diese Aufgabe wird gelöst durch ein Lichtgitter mit den Merkmalen des Anspruchs 1.

Das erfindungsgemäße Lichtgitter umfasst:
- mehrere Lichtsendeeinheiten zur Aussendung von Sendelichtstrahlen,
- mehrere Lichtempfangseinheiten, die entsprechend dem Lichteinfall Empfangssignale liefern und die zur Bildung des Lichtgitters die Sendelichtstrahlen empfangen können bei freiem Strahlengang,
- wenigstens eine Empfangsoptik,
- eine Auswerteeinheit zur Auswertung der Intensität des Lichteinfalls auf die Lichtempfangseinheiten.

Erfindungsgemäß umfasst die Empfangsoptik ein Substrat, das ein Mikrolinsenarray aufweist, wobei jeder Mikrolinse eine Blende zugeordnet ist und die Blenden liegen jeweils im Brennpunkt der zugeordneten Mikrolinse zur Einschränkung eines Sichtbereichs der Lichtempfangseinheiten. Jeweils eine Gruppe von Mikrolinsen des Mikrolinsenarrays ist je einer Lichtempfangseinheit zugeordnet.

Die so ausgebildete Struktur schränkt den Sichtbereich der zugeordneten Lichtempfangseinheit (also Empfangswinkel) effektiv ein, wobei gleichzeitig einerseits aufgrund der kurzen Brennweiten von Mikrolinsen effektiv Bauraum gespart wird und andererseits die Fläche, auf der Licht, das die Lichtempfangseinheit auch nachweisen kann, einfallen kann, nicht kleiner ist als in bekannten Lichtgittern. Im Gegenteil, diese Fläche kann sogar vergrößert werden ohne dass sich die Baurautiefe ändert. In herkömmlichen Lichtgittern wurde die Empfangsfläche über die Größe der Empfangslinse bestimmt und die Photodiode kann klein sein. Nach Erfindung ist dieses Prinzip umgedreht, denn jetzt wird die Empfangsfläche über die Größe der Photodiode bestimmt. In der erfindungsgemäßen Ausbildung ist eine genaue Zuordnung zwischen einer einzelnen Lichtempfangseinheit (Photodiode) und bestimmten Empfangsoptiken nicht notwendig und deshalb nicht vorgesehen.

Allein jedes Paar aus Mikrolinse und zugeordneter Blende wirkt für sich als empfangswinkeleinschränkendes Element. Je nach Größe der lichtempfindlichen Fläche einer Lichtempfangseinheit sind eine bestimmte Anzahl der Mikrolinsen der Lichtempfangseinheit "zugeordnet", nämlich gerade die, die über der lichtempfindlichen Fläche Iiegen. Dadurch wird ein weiterer Vorteil deutlich. Eine bestimmte Ausrichtung der erfindungsgemäßen Empfangsoptik gegenüber einem Lichtempfangselement ist nicht notwendig.

Durch Variation der Mikrolinsengeometrie, Mikrolinsendicke, Blendendurchmesser und Materialstärke der Blende kann der Empfangswinkel eingestellt werden und optisches Übersprechen zwischen benachbarten Kanälen minimiert werden. Licht aus dem Sichtfeld wird empfangen und außerhalb des Sichtfelds effektiv unterdrückt.

Darüber hinaus kann das mikrostrukturierte Substrat sehr dünn und damit sehr platzsparend ausgeführt werden, zum Beispiel als Folie.

Weiter ist die Herstellung erfindungsgemäßer Lichtgitter erheblich vereinfacht. Anstatt wie bisher mehrere Komponenten, nämlich Linse und Tubus sowie die Lichtempfangseinheiten (Photodioden) aufweisenden Elektronikkarte einzeln fügen zu müssen, wird nur ein Element, nämlich das mikrostrukturierte Substrat, in einfacher Weise aufgebracht, vorzugsweise geklebt.

In vorteilhafter Weise sind die Lichtempfangseinheiten jeweils als Photodiode oder Avalanche-Photodiode (APD) oder SPAD-Array (Single-Photon-Avalanche-Diode) ausgebildet. Je Photodiode, APD oder SPAD-Array gibt es eine bestimmte Gruppe von Mikrolinsen des Mikrolinsenarrays. Der besondere Vorteil ist dabei, dass dann die horizontale Ausrichtung zwischen dem Substrat mit den Mikrolinsen und den Blenden einerseits und der Lichtempfangseinheiten andererseits nicht exakt sein muss. Diese Toleranz vereinfacht die Herstellung erheblich. Alternativ könnten die Lichtempfangseinheiten auch als eine gemeinsame Photodiodenzeile ausgebildet sein.

In besonders günstiger und einfacher Weise ist das Substrat mit dem Mikrolinsenarray und den Blenden als Folie ausgebildet. Dabei kann ein Stück der mikrostrukturierte Folie jeweils nur ein Lichtempfangselement abdecken, die Folie weist also mehrere einzelne Mikrolinsenarrays auf. Bevorzugt ist das Mikrolinsenarray der Folie mit den zugehörigen Blenden aber durchgehend ausgebildet, so dass die Folie allen Lichtempfangseinheiten zugeordnet ist. So kann die Folie als länglicher Streifen alle Photodioden eines Lichtgitters oder zumindest alle Photodioden eines Teils des Lichtgitters, wenn dieses modular aufgebaut ist, abdecken. Mit wenigen Montageschritten ist die gesamte Empfangsoptik korrekt montiert. Vorzugsweise wird ein Mikrolinsenfolienstreifen je Elektronikkarte verwendet, um Vorbaugruppen realisieren zu können und die temperaturbedingte Ausdehnungsdifferenz lokal zu halten. Aber prinzipiell ist auch ein Folienstreifen über die gesamte Lichtgitterlänge denkbar, dann eventuell mit Dehnfugen in der Folie zwischen den Photodioden, um die temperaturbedingte Ausdehnungsdifferenz zwischen Folie und Träger auszugleichen.

Besonders vorteilhaft ist dann auch eine Ausbildung wonach das Substrat an seiner die Blenden aufweisenden Oberfläche klebend ausgebildet ist. Das mikrostrukturierte Substrat kann somit einfach auf die Photodioden, auf ein Abschirmblech oder ein anderes Element vor den Photodioden aufgebracht, also aufgeklebt, werden. Alternativ könnte das Substrat auch an die Außenfläche einer Frontscheibe eines Gehäuses geklebt werden. In einer weiteren Alternative wird die Mikrolinsenseite klebend ausgebildet und die Folie auf die Innenseite des Frontfensters aufgebracht.

Vorteilhafterweise grenzen die Mikrolinsen eines Mikrolinsenarrays lückenfrei aneinander, um die Transmission des Substrats zu maximieren. Ohne Lücken wird alles Licht abzüglich Transmissionsverlusten aus dem Sichtbereich auf die Blendenöffnungen und damit auf die Empfangseinheit abgebildet.

Solche lückenfrei aneinander angrenzende Mikrolinsen sind in Weiterbildung der Erfindung sechseckig ausgebildet.

Zur kostengünstigen Herstellung ist es vorteilhaft, das Mikrolinsenarray in einem Prägeverfahren herzustellen.

Eine besonders einfache und damit kostengünstige Herstellung für die Blenden ist gegeben, wenn die Blenden aus einer lichtdichten Beschichtung mit Blendenöffnungen gebildet sind. Durch bekannte Beschichtungsverfahren, z.B. Lackieren, Ätzen, Lithografie oder dergleichen, lässt sich eine solche Beschichtung effizient fertigen. Alternativ besteht die Blendenschicht aus Metall.

Die Blendenöffnungen selbst können nicht nur runde sondern auch elliptische, quadratische, oder rechteckige Form haben, wenn statt einem runden ein elliptisches, quadratisches bzw. rechteckförmiges Sichtfeld realisiert werden soll.

In Weiterbildung der Erfindung weist das Substrat eine Randkontur auf. Mittels dieser Randkontur kann das Substrat relativ zu den Photodioden über beispielsweise Aufnahmestifte festgelegt werden.

In Weiterbildung der Erfindung weist das Substrat ein spektrales Filter auf, das dann spektral auf das Sendelicht abgestimmt ist, so dass dadurch eine weitere Unterdrückung von Fremdlicht erreicht werden kann.

In Weiterbildung der Erfindung weist das Substrat eine polarisationswirksame Funktion auf, was ebenfalls zur Unterdrückung von Fremdlicht vorteilhaft genutzt werden kann.

Die Folie bzw. das Substrat mit den Mikrolinsen kann auch unterschiedliche Bereiche mit unterschiedlichen Mikrolinsen-Blenden-Kombinationen aufweisen, um beispielsweise unterschiedliche Sichtbereiche des Lichtgitters einfach zu realisieren. Diese Bereiche können z.B. schachbrettartig auf der Folie angeordnet sein.

Im Folgenden wird die Erfindung anhand von Ausführungsbeispielen unter Bezugnahme auf die Zeichnung im Einzelnen erläutert. In der Zeichnung zeigen:
- Fig. 1: eine schematische Darstellung eines erfindungsgemäßen Lichtgitters;
- Fig. 2: eine schematische Darstellung einer oder eines Teils einer Empfangsoptik und Lichtempfangseinheit;
- Fig. 3: schematische Darstellung einer Draufsicht auf ein Mikrolinsenarray.

Ein erfindungsgemäßes Lichtgitter 10 weist ein Sendergehäuse 12 und ein Empfängergehäuse 14 auf, die einerseits eine in Längsrichtung (im Folgenden auch y-Richtung) angeordnete Reihe von Lichtsendeeinheiten 18 aufweisen bzw. eine in Längsrichtung angeordnete Reihe von Lichtempfangseinheiten 20. Jeder Lichtsendeeinheit 18 ist gegenüberliegend eine Empfangseinheit 20 zugeordnet, so dass zwischen Sender-Empfänger-Paaren jeweils Lichtstrahlen liegen, die vereinfacht in dieser Darstellung als Pfeile 22 symbolisiert sind. Jede Lichtsendeeinheit 18 umfasst bevorzugt eine Sendeoptik, die die Sendelichtstrahlen 22 formt. Den Lichtempfangseinheiten 20 ist eine Empfangsoptik 26 vorgeordnet, um Licht auf die Lichtempfänger 20 zu führen, wie weiter unten noch detailliert dargestellt ist.

Die Lichtstrahlenbündel 22 definieren in ihrer Gesamtheit eine Überwachungsebene 24, die daraufhin überwacht wird, ob eine oder mehrere der Lichtstrahlenbündel 22 von einem nicht dargestellten Objekt ganz oder teilweise unterbrochen werden. Eine solche Unterbrechung wird in einer Auswerteeinheit 32, die die Empfangssignale aller Lichtempfangseinheiten 20 nach Verstärkung 30 auswertet, erkannt und ein entsprechendes Signal an einem Ausgang 32 ausgegeben. Das Ausgangssignal kann ein einfaches Schaltsignal ("Objekt in Schutzfeld ja/nein") oder ein Signal mit mehr Information sein, z. B. wo sich das Objekt befindet. Senderseitig ist eine Ansteuerelektronik 28 zur Ansteuerung der Lichtsender 18 vorgesehen.

Die Sendeeinheiten 18 und die Lichtempfangseinheiten 20 haben in ihrer Reihe einen üblicherweise gleichmäßigen Abstand A zueinander, der auch als Rastermaß bezeichnet wird. Für spezielle Anwendungen kann es auch sinnvoll sein, ein unregelmäßiges Raster zu wählen. Jeder Lichtsendeeinheit liegt eine Lichtempfangseinheit gegenüber. Die Zuordnung von einer aktivierten Lichtsendeeinheit 18 zu einer aktivierten Lichtempfangseinheit erfolgt durch die Steuereinheit 28 und die Auswerteeinheit 32, die miteinander synchronisiert sind und Synchronisationssignale über eine Kommunikationsverbindung 36 austauschen können.

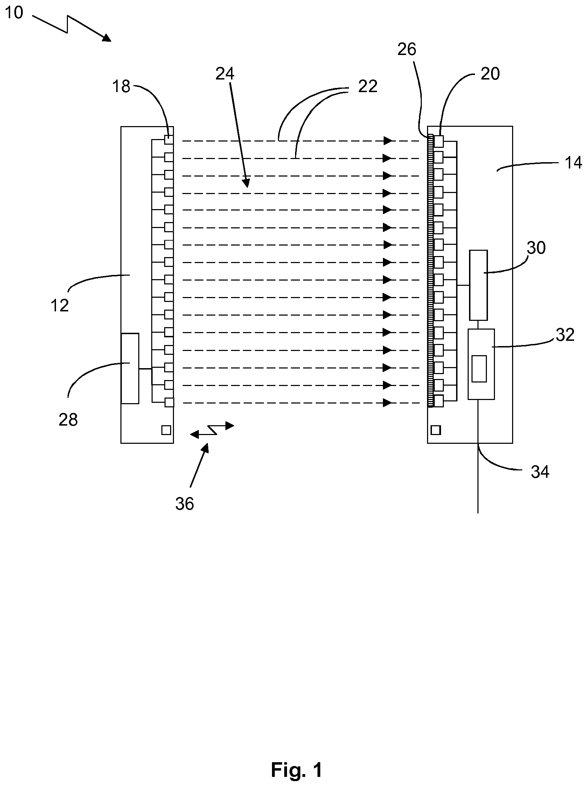

Sind genau gegenüberliegende Sender/Empfänger zeitgleich aktiviert, dann setzt sich die Überwachungsebene aus den in Fig. 1 schematisch dargestellten Strahlenbündeln 22 zusammen. Dabei sind in bekannter Weise typischerweise nicht alle Sender 18 gleichzeitig aktiviert, sondern es werden die Sender 18 und zugehörigen Empfänger 20 einzeln in schneller Folge zyklisch durchgeschaltet (aktiviert), so dass immer nur ein Sender-Empfänger-Paar und damit ein Strahlenbündel aktiviert ist. Die Zyklusfrequenz (Taktfrequenz) ist sehr hoch, so dass Objekte, die sich durch die Überwachungsebene bewegen oder durch die Ebene 24 gefördert werden, quasistationär sind.

Die Erfindung bezieht sich nun auf die Empfangsoptik 26. Die Empfangsoptik 26 dient dazu, Licht, das aus einer bestimmten Richtung, nämlich aus der Richtung, in der sich die jeweils zugeordnete Lichtsendeeinheit 18 befindet, auf die Lichtempfangseinheiten 20 zu führen. Es sollen also jeweils der "richtige" Lichtstrahl 22 und möglichst nichts Anderes empfangen werden.

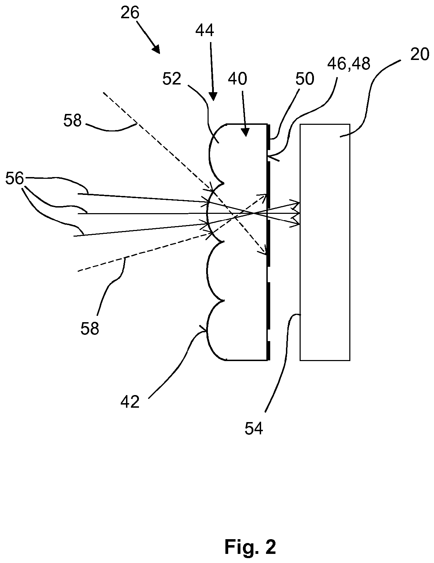

Die erfindungsgemäße Empfangsoptik 26, die in Fig. 2 detaillierter aber immer noch schematisch dargestellt ist, umfasst jetzt ein Substrat 40, an dessen einen Seite 42, nämlich der lichtstrahlenzugewandten Seite, ein Mikrolinsenarray 44 ausgebildet ist und auf dessen gegenüberliegenden, der Lichtempfangseinheit zugewandten Seite 46 Blenden 50 ausgebildet sind, wobei jeder Mikrolinse 52 eine der Blenden 50 zugeordnet ist und die Blenden 50 jeweils idealerweise im Brennpunkt der zugeordneten Mikrolinse 52 liegen. Mit dem Begriff "im Brennpunkt" soll also gemeint sein, dass vorzugsweise die Blende im Brennpunkt einer Mikrolinse liegt oder zumindest in der Nähe, wenn es Toleranzen gibt.

Die Mikrolinsen können für einen mechanischen Schutz mit einer transparenten Schutzschicht vergossen werden. Der Brechungsindex der Schutzschicht sollte möglichst klein sein. Die Linsenkontur muss entsprechend der Brechungsindizes angepasst werden, damit die Blenden nach wie vor im Brennpunkt des Systems stehen. Auch die Blenden selbst müssen nicht unbedingt an einer Oberfläche 48 vorgesehen sein, sondern die Blenden können auch in der Struktur vorgesehen sein, bzw. es kann auch auf der Blendenseite eine Schutzschicht vorgesehen sein.

Die so ausgebildete Struktur 40 schränkt den Sichtbereich, also den Empfangswinkel Ω, der zugeordneten Lichtempfangseinheit 20 auf einen durch die Mikrolinsen 52 und die Blendenöffnung definierten Wert ein. Nur die Lichtstrahlen 56 innerhalb dieses Winkels Ω erreichen die Lichtempfangseinheit. Alles Licht, das durch die Blendenöffnung tritt, trifft auf die dahinterliegende Lichtempfangseinheit 20, die unmittelbar anschließend oder zumindest in kleinem Abstand hinter den Blenden 50 angeordnet ist. Diejenigen Mikrolinsen 52, die eine Lichtempfangsfläche 54 einer Lichtempfangseinheit 20 abdecken, definieren die Licht empfangende Fläche und führen das Licht auf die Lichtempfangseinheit 20. Wenn die Lichtempfangseinheiten 20 einen Abstand voneinander haben und das mikrostrukturierte Substrat 40 durchgehend ist, dann wird die Licht empfangende Fläche immer nur durch die Mikrolinsen 52 definiert, die einen Lichtempfänger 20 vorgeordnet sind. Die Mikrolinsen, die "dazwischen" sitzen, sind inaktiv. Das macht gerade einen der großen Vorteile der Erfindung aus. Denn dann braucht es keine Zuordnung von Empfangsoptik zu Lichtempfänger, sondern es muss lediglich sichergestellt sein, dass die Struktur die Lichtempfänger abdeckt.

Dabei wirkt jedes Paar aus Mikrolinse 52 und zugeordneter Blende 50 für sich als empfangswinkeleinschränkendes Element. Durch Variation der Mikrolinsengeometrie, Mikrolinsendicke, Blendendurchmesser und Materialstärke der Blende kann der Empfangswinkel Ω eingestellt werden. In Fig. 2 sind beispielhaft zwei Lichtstrahlen 58 außerhalb des Empfangswinkels Ω als gestrichelte Linien dargestellt. Ein optisches Übersprechen zwischen benachbarten Kanälen kann minimiert werden.

In vorteilhafter Weise sind die Lichtempfangseinheiten 20 jeweils als Photodioden ausgebildet sind. Somit sind einer Photodiode eine Vielzahl von Mikrolinsen 52 zugeordnet. Die Lichtempfangseinheiten könnten auch als Avalanche-Photodiode (APD) oder SPAD-Array (Single-Photon-Avalanche-Diode) ausgebildet sein. Je Photodiode, APD oder SPAD-Array gibt es eine bestimmte Gruppe von Mikrolinsen des Mikrolinsenarrays, die das Licht aus dem Empfangswinkel auf den Lichtempfänger führen.

Alternativ könnten die Lichtempfangseinheiten auch als eine gemeinsame Photodiodenzeile ausgebildet sein. Dann wäre es sinnvoll, dass die Lichtsendeeinheit eine Lichtlinie aussendet, die in Photodiodenzeilenrichtung ausgerichtet ist. Der Vorteil wäre die Möglichkeit einer lückenlosen Überwachung der Überwachungsebene 24.

Das mikrostrukturierte Substrat 40 kann sehr dünn und damit sehr platzsparend ausgeführt werden. Insbesondere ist das Substrat 40 mit dem Mikrolinsenarray 44 und den Blenden 50 als Folie ausgebildet. Dabei kann ein Stück mikrostrukturierte Folie 60 jeweils nur ein Lichtempfangselement abdecken, weist also nur ein Mikrolinsenarray 44 auf. Bevorzugt ist aber, dass - wie in Fig. 1 angedeutet - die Folie 60 ein durchgehendes Mikrolinsenarray 44 bildet und damit insbesondere alle Photodioden abdeckt. So ist die Folie 60 als länglicher Streifen ausgebildet und deckt alle Photodioden 20 des Lichtgitters 10 ab.

Die Folie 60 mit den Blenden 50 ist auf der Blendenseite 46 klebend ausgebildet, so dass sie auf die Photodioden 20, auf ein nicht dargestelltes Abschirmblech oder ein anderes Element vor den Photodioden 20 aufgeklebt werden kann.

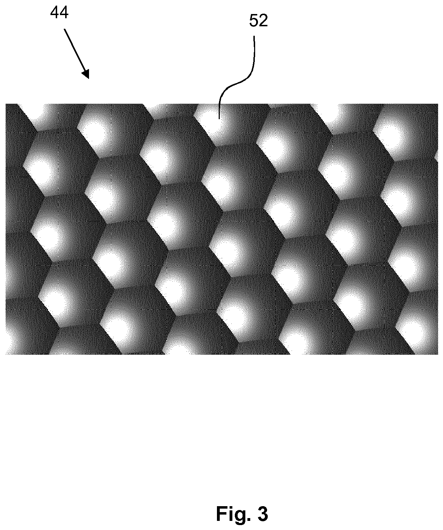

In Fig. 3 ist die Draufsicht auf einen Ausschnitt eines der Mikrolinsenarrays 44 dargestellt. Vorzugsweise grenzen die Mikrolinsen 52 des Mikrolinsenarrays 44 lückenfrei aneinander, um die Transmission des Substrats 40 zu maximieren. Ohne Lücken wird alles Licht bis auf Transmissionsverluste aus dem Sichtbereich auf die Blendenöffnungen und damit auf die Lichtempfangseinheit 20 abgebildet. Solche lückenfrei aneinander angrenzende Mikrolinsen 52 sind in der bevorzugten Ausführungsform sechseckig ausgebildet.

Die einzelnen Mikrolinsen 44 können beispielsweise als Asphärenlinsen, Freiformlinsen, Fresnellinsen oder diffraktive Linsen ausgebildet sein.

Anstatt einer zweidimensionalen Sichtfeldeinschränkung kann eine eindimensionale Einschränkung des Empfangswinkels realisiert werden, wenn die Mikrolinsen als Mikrozylinderlinsen und die Blendenöffnungen streifenförmig ausgebildet sind.

## Patentansprüche

1. Lichtgitter mit
- mehreren Lichtsendeeinheiten (18) zur Aussendung von Sendelichtstrahlen (22),
- mehreren Lichtempfangseinheiten (20), die entsprechend dem Lichteinfall Empfangssignale liefern und die zur Bildung des Lichtgitters (10) die Sendelichtstrahlen (22) empfangen können bei freiem Strahlengang,
- wenigstens einer Empfangsoptik (26),
- einer Auswerteeinheit (32) zur Auswertung der Intensität des Lichteinfalls auf die Lichtempfangseinheiten (20),
**dadurch gekennzeichnet,**
- **dass** die Empfangsoptik (26) ein Substrat (40) umfasst, das ein Mikrolinsenarray (44) aufweist,
- wobei jeder Mikrolinse (52) eine Blende (50) zugeordnet ist
- und die Blenden (50)jeweils im Brennpunkt der zugeordneten Mikrolinse (52) liegen zur Einschränkung eines Sichtbereichs der Lichtempfangseinheiten (20)
- und **dass** je einer Lichtempfangseinheit jeweils eine Gruppe von Mikrolinsen des Mikrolinsenarrays zugeordnet ist.

2. Lichtgitter nach Anspruch 1, **dadurch gekennzeichnet, dass** die Lichtempfangseinheiten jeweils als Photodiode oder Avalanche-Photodiode (APD) oder SPAD-Array (Single-Photon-Avalanche-Diode) ausgebildet sind, oder die Lichtempfangseinheiten als eine Photodiodenzeile ausgebildet ist.

3. Lichtgitter nach einem der vorhergehenden Ansprüche, **dadurch gekennzeichnet, dass** das Substrat mit dem Mikrolinsenarray und den Blenden als Folie ausgebildet ist.

4. Lichtgitter nach Anspruch 3, **dadurch gekennzeichnet, dass** die Folie mit dem Mikrolinsenarray mit Blenden mehrere, insbesondere alle Lichtempfangseinheiten abdeckt, also allen zugeordnet ist.

5. Lichtgitter nach einem der vorhergehenden Ansprüche, **dadurch gekennzeichnet, dass** die Mikrolinsen sechseckig ausgebildet sind.

6. Lichtgitter nach einem der vorhergehenden Ansprüche, **dadurch gekennzeichnet, dass** das Mikrolinsenarray in einem Prägeverfahren hergestellt ist.

7. Lichtgitter nach einem der vorhergehenden Ansprüche, **dadurch gekennzeichnet, dass** die Blenden aus einer lichtdichten Beschichtung mit Blendenöffnungen gebildet sind.

8. Lichtgitter nach einem der vorhergehenden Ansprüche, **dadurch gekennzeichnet, dass** die Blendenöffnungen eine elliptische, quadratische, oder rechteckige Form haben.

9. Lichtgitter nach einem der vorhergehenden Ansprüche, **dadurch gekennzeichnet, dass** das Substrat an seiner die Blenden aufweisenden Oberfläche klebend ausgebildet ist.

10. Lichtgitter nach einem der vorhergehenden Ansprüche, **dadurch gekennzeichnet, dass** das Substrat eine Randkontur zur Festlegung aufweist.

11. Lichtgitter nach einem der vorhergehenden Ansprüche, **dadurch gekennzeichnet, dass** die Mikrolinsen und/oder die Blenden mit einer transparenten Schutzschicht vergossen sind.

12. Lichtgitter nach einem der vorhergehenden Ansprüche, **dadurch gekennzeichnet, dass** das Substrat ein spektrales Filter aufweist.

13. Lichtgitter nach einem der vorhergehenden Ansprüche, **dadurch gekennzeichnet, dass** das Substrat eine polarisationswirksame Funktion aufweist.

14. Lichtgitter nach einem der vorhergehenden Ansprüche, **dadurch gekennzeichnet, dass** das Substrat mit den Mikrolinsen unterschiedliche Bereiche mit unterschiedlichen Mikrolinsen-Blenden-Kombinationen aufweist.

## Claims

1. Light grid with
- a plurality of light emitting units (18) for emitting transmitted light beams (22),
- a plurality of light-receiving units (20) which supply reception signals in accordance with the incidence of light and which, in order to form the light grid (10), are capable of receiving the transmitted light beams (22) when the beam path is free,
- at least one receiving optics (26),
- an evaluation unit (32) for evaluating the intensity of the light incident on the light-receiving units (20),
**characterized in that**
- **in that** the receiving optics (26) comprise a substrate (40) having a microlens array (44),
- wherein each microlens (52) is associated with an aperture (50)
- and the apertures (50) each lie in the focal point of the associated microlens (52) for limiting a field of view of the light receiving units (20)
- and **in that** a group of microlenses of the microlens array is assigned to each light-receiving unit.

2. Light grid according to claim 1, **characterized in that** the light receiving units are each formed as a photodiode or avalanche photodiode (APD) or SPAD array (single photon avalanche diode), or the light receiving units is formed as a linear photodiode array.

3. Light grid according to any one of the preceding claims, **characterized in that** the substrate with the microlens array and the apertures is formed as a film.

4. Light grid according to claim 3, **characterized in that** the film with the microlens array with apertures covers a plurality of light-receiving units, in particular all light-receiving units, i.e. is assigned to all of them.

5. Light grid according to any one of the preceding claims, **characterized in that** the microlenses are hexagonal in shape.

6. Light grid according to any one of the preceding claims, **characterized in that** the microlens array is produced by an embossing process.

7. Light grid according to any one of the preceding claims, **characterized in that** the apertures are formed from an opaque coating having aperture openings.

8. Light grid according to any one of the preceding claims, **characterized in that** the aperture openings have an elliptical, square, or rectangular shape.

9. Light grid according to any one of the preceding claims, **characterized in that** the substrate is made adhesive at its surface comprising the apertures.

10. Light grid according to any one of the preceding claims, **characterized in that** the substrate has an edge contour for fixing.

11. Light grid according to any one of the preceding claims, **characterized in that** the microlenses and/or the apertures are encapsulated with a transparent protective layer.

12. Light grid according to any one of the preceding claims, **characterized in that** the substrate comprises a spectral filter.

13. Light grid according to any one of the preceding claims, **characterized in that** the substrate has a polarization effective function.

14. Light grid according to any one of the preceding claims, **characterized in that** the substrate with the microlenses comprises different regions with different microlens-aperture combinations.

## Revendications

1. Grille de lumière avec
- une pluralité d'unités d'émission de lumière (18) pour émettre des faisceaux lumineux transmis (22),
- une pluralité d'unités de réception de lumière (20) qui fournissent des signaux de réception en fonction de l'incidence de la lumière et qui, pour former la grille de lumière (10), sont capables de recevoir les faisceaux lumineux émis (22) lorsque le trajet des faisceaux est libre,
- au moins une optique de réception (26),
- une unité d'évaluation (32) pour évaluer l'intensité de la lumière incidente sur les unités de réception de lumière (20),
**caractérisé**
- **en ce que** l'optique de réception (26) comprend un substrat (40) ayant un réseau de microlentilles (44),
- dans lequel chaque microlentille (52) est associée à une ouverture (50)
- et les ouvertures (50) se trouvent chacune dans le point focal de la microlentille (52) associée pour limiter un champ de vision des unités de réception de lumière (20)
- et **en ce qu'**un groupe de microlentilles du réseau de microlentilles est affecté à chaque unité de réception de la lumière.

2. Grille de lumière selon la revendication 1, **caractérisée en ce que** les unités de réception de lumière sont chacune formées comme une photodiode ou une photodiode à avalanche (APD) ou un réseau SPAD (diode à avalanche à photon unique), ou les unités de réception de lumière sont formées comme un réseau de photodiode linéaire.

3. Grille de lumière selon l'une quelconque des revendications précédentes, **caractérisée en ce que** le substrat avec le réseau de microlentilles et les ouvertures est formé comme un film.

4. Grille de lumière selon la revendication 3, **caractérisée en ce que** le film avec le réseau de microlentilles avec des ouvertures couvre une pluralité d'unités de réception de lumière, en particulier toutes les unités de réception de lumière, c'est-à-dire qu'il est affecté à toutes celles-ci.

5. Grille de lumière selon l'une quelconque des revendications précédentes, **caractérisée en ce que** les microlentilles sont de forme hexagonale.

6. Grille de lumière selon l'une quelconque des revendications précédentes, **caractérisée en ce que** le réseau de microlentilles est réalisé par un procédé de gaufrage.

7. Grille de lumière selon l'une quelconque des revendications précédentes, **caractérisée en ce que** les ouvertures sont formées à partir d'un revêtement opaque présentant des ouvertures d'ouverture.

8. Grille de lumière selon l'une quelconque des revendications précédentes, **caractérisée en ce que** les ouvertures d'ouverture ont une forme elliptique, carrée ou rectangulaire.

9. Grille de lumière selon l'une quelconque des revendications précédentes, **caractérisée en ce que** le substrat est rendu adhésif à sa surface comportant les ouvertures.

10. Grille de lumière selon l'une quelconque des revendications précédentes, **caractérisée en ce que** le substrat présente un contour de bord pour la fixation.

11. Grille de lumière selon l'une quelconque des revendications précédentes, **caractérisée en ce que** les microlentilles et/ou les ouvertures sont encapsulées avec une couche protectrice transparente.

12. Grille de lumière selon l'une quelconque des revendications précédentes, **caractérisée en ce que** le substrat comprend un filtre spectral.

13. Grille de lumière selon l'une quelconque des revendications précédentes, **caractérisée en ce que** le substrat a une fonction efficace de polarisation.

14. Grille de lumière selon l'une quelconque des revendications précédentes, **caractérisée en ce que** le substrat avec les microlentilles comprend différentes régions avec différentes combinaisons microlentilles-ouverture.
